# EUROPÄISCHE PATENTSCHRIFT

(11) **EP 1 248 499 B1**
(45) Veröffentlichungstag und Bekanntmachung des Hinweises auf die Patenterteilung: **26.05.2010**
(21) Anmeldenummer: 01125762.3
(22) Anmeldetag: 29.10.2001
(51) Int. Cl.: H05G 2/00

(54) **Verfahren und Vorrichtung zum Erzeugen von extrem ultravioletter Strahlung**
Method and apparatus for production of extreme ultraviolet radiation
Procédé et dispositif pour produire du rayonnement extrême ultraviolet

(30) Priorität: 06.04.2001 DE 10117377; 11.08.2001 DE 10139677
(43) Veröffentlichungstag der Anmeldung: 09.10.2002
(73) Patentinhaber: Fraunhofer-Gesellschaft zur Förderung der angewandten Forschung e.V., 80686 München (DE); Philips Intellectual Property & Standards GmbH, 20099 Hamburg (DE); Koninklijke Philips Electronics N.V., 5621 BA Eindhoven (NL)
(72) Erfinder: Klein, Jürgen, Dr., 52072 Aachen (DE); Seiwert, Stefan, 52074 Aachen (DE); Neff, Willi, Dr., 4721 Kelmis (BE); Bergmann, Klaus, Dr., 52134 Herzogenrath (DE); Pankert, Joseph, Dr., 52074 Aachen (DE); Löken, Michael, 52428 Jülich (DE)
(74) Vertreter: Gagel, Roland

(56) Entgegenhaltungen:
- DE-A- 19 753 696
- US-A- 4 201 921
- US-A- 4 596 030

## Beschreibung

Die Erfindung bezieht sich auf ein Verfahren mit den Merkmalen des Oberbegriffs des Anspruchs 1.

Ein Verfahren mit den vorangesprochenen Verfahrensschritten ist aus der DE-A-197 53 696 bekannt. Das Verfahren wird mit einer Vorrichtung durchgeführt, die ein den Entladungsraum bildendes Elektrodensystem aufweist. Mit diesem Elektrodensystem wird extrem ultraviolette Strahlung und weiche Röntgenstrahlung erzeugt, die insbesondere für die EUV-Lithographie eingesetzt werden. Das Elektrodensystem besteht aus zwei Elektroden, nämlich einer Kathode und einer Anode, die jeweils mit einer Öffnung ausgebildet sind. Die Öffnung ist im wesentlichen ein Loch und beide Öffnungen liegen auf einer gemeinsamen Symmetrieachse. Die Kathode ist als Hohlkathode ausgebildet, weist also einen Hohlraum auf. Dieser wird dazu benutzt, das elektrische Feld in vorbestimmter Weise auszubilden. Insbesondere ist die Anordnung der Elektroden so, daß die Feldlinien im Bereich der Bohrlöcher genügend gestreckt sind, damit der Durchbruchbedingung oberhalb einer bestimmten Spannung entsprochen wird. Der Entladungsraum ist mit Gas gefüllt und der Gasdruck ist zumindest im Bereich des Elektrodensystems in der Größenordnung von 1 Pa bis 100 Pa. Die Geometrie der Elektroden und der Gasdruck sind so gewählt, daß die angestrebte Zündung des Plasmas auf dem linken Ast der Paschenkurve erfolgt und infolgedessen kein dielektrischer Durchbruch zwischen den Elektroden außerhalb der Öffnungen auftritt. Infolge der Zündung bildet sich ein stromführender Plasmakanal axialsymmetrischer Form aus, nämlich im Bereich der Öffnungen der Elektroden. Mit Hilfe des Energiespeichers wird dazu über diesen Kanal ein Strom geschickt. Die daraus resultierende Lorentz-Kraft schnürte das Plasma ein. Infolge dieses Einschnürungseffekts und durch ohmsche Heizung treten im Plasma sehr hohe Temperaturen auf und es wird Strahlung sehr kurzer Wellenlänge erzeugt. Die bekannte Vorrichtung kann EUV-Licht im Wellenlängenbereich von 10-20 nm erzeugen.

Für das Verfahren ist wesentlich, daß auf ein Schaltelement zwischen dem Elektrodensystem und dem Energiespeicher grundsätzlich verzichtet werden kann. Daher läßt sich eine niederinduktive und effektive Einkopplung der elektrisch gespeicherten Energie in das Elektrodensystem erreichen. Pulsenergien von wenigen Joule sind ausreichend, um Strompulse im Bereich von mehreren Kiloampere bis zu einigen 10 Kiloampere auszulösen. Eine Auslösung der Energieeinkopplung in die gesteuert oder im Selbstdurchbruch betriebene Entladung erfolgt unter Abstimmung auf eine vorbestimmte Zündspannung. Die Zündspannung wird beispielsweise durch die Gaszusammensetzung, die Temperatur, eine Vorionisierung, die elektrische Feldverteilung und andere Größen beeinflußt. Sie kann entsprechend der Paschenkurve mittels des Gasdrucks des Entladungsgefäßes eingestellt werden. Bis zu dieser Zündspannung muß auch der Energiespeicher aufgeladen werden, um dann im Falle der Zündung möglichst viel Energie in das Plasma einspeisen zu können. Die Einspeisung gespeicherter Energie in eine im Selbstdurchbruch betriebene Entladung erfolgt mit dem Durchbruch, also mit dem Zünden des Plasmas selbsttätig. Dabei ist jedoch zu berücksichtigen, daß ein ungetriggertes Entladungssystem nur einen einzigen Durchbruchspunkt hat, der durch die Bedingungen der Paschenkurve festgelegt ist. Dieser Punkt ist nicht stabil. Wenn sich das Elektrodensystem insbesondere im Entladungsraum aufheizt, wird der Durchbruch nicht mehr bei derselben Spannung stattfinden.

Ferner wiederholen sich Durchbrüche in schneller Folge, um fortdauernd Strahlung zu erzeugen. Zwischen zwei Durchbrüchen benötigt das System eine bestimmte Zeit zur Rekombination des Gases im Entladungsraum. Während dieser Zeit kehrt das Gas zumindest zum Teil wieder in seinen Ausgangszustand zurück, so daß der Energiespeicher erneut geladen und an seinen Elektroden die erforderliche Spannung aufgebaut werden kann. Infolgedessen hängt der Zustand des Systems auch davon ab, wann der letzte Durchbruch stattgefunden hat bzw. mit welcher Wiederholfrequenz die Erzeugung der Strahlung erfolgte. Bei hoher Wiederholfrequenz wird der auf der Paschenkurve liegende Arbeitspunkt anders sein, als bei niedriger Wiederholfrequenz. In der Praxis bedeutet das, daß die Wiederholfrequenz sehr begrenzt sein kann, weil überhaupt kein stabiler Arbeitspunkt mehr gefunden werden kann. Im Zusammenhang damit bestehen Probleme dahingehend, daß nicht schnell von einer Wiederholfrequenz auf eine andere umgeschaltet werden kann und daß auch bei einer bestimmten Wiederholfrequenz nicht wiederholt ein- und ausgeschaltet werden kann. Das Einund Ausschalten ist insbesondere wichtig, wenn ein Lithographiegerät betrieben wird, bei dem zwischen Belichtungsvorgängen Pausen eingelegt werden müssen, um Einstellungen am Gerät vorzunehmen.

Der Erfindung liegt die Aufgabe zugrunde, ein Verfahren mit den eingangs genannten Verfahrensschritten so zu verbessern, daß bei im Impulsbetrieb durchgeführten Verfahren zur Erzeugung des EUV-Lichts eine genaue Steuerung der Pulse erreicht werden kann, insbesondere in einem weiten Parameterfeld der Entladungsvorgänge.

Diese Aufgabe wird durch die Merkmale des Kennzeichens des Anspruchs 1 gelöst.

Mit der Triggerung wird Einfluß auf die Zündbedingungen für das Plasma genommen. Insbesondere wird mit der Triggerung die Verteilung von Ladungsträgern im Zündbereich des Plasmas beeinflußt und damit auch der Zeitpunkt, zu dem die Zündung effektiv erfolgt. Dabei ist das Potential der Triggerelektrode vor Beginn des Triggervorgangs höher, als das der Kathode. Infolgedessen wird ein solcher Einfluß auf die Feldausbildung im Entladungsraum genommen, daß es nicht zum Durchbruch kommen kann. Dieser ist erst möglich, wenn das den Durchbruch behindernde Potential beseitigt ist.

In spezieller Weise wird das Verfahren so durchgeführt, daß eine Spannung der Triggerelektrode gegenüber der als Kathode verwendeten Elektrode, die Spannung an den beiden Elektroden und der Gasdruck des Entladungsraums so eingestellt werden, daß bei Anliegen der Triggerspannung eine Zündung des Plasmas nicht erfolgt, die erst mittels Abschaltens der Triggerspannung eingeleitet wird. Das Abschalten der Triggerspannung ermöglicht eine solche Ausbildung des elektrischen Feldes im Entladungsraum, daß die Durchbruchsbedingungen erfüllt sind. Der Zeitpunkt des Durchbruchs kann durch das Triggersignal, nämlich das Abschalten der Triggerspannung, genau festgelegt werden. Von Bedeutung ist auch, daß der Parameterbereich für eine Entladung erheblich erweitert werden kann. Der Druck im Gasraum, der Abstand der Elektroden und die Spannung an den Elektroden können in Abhängigkeit der Triggerspannung unterschiedlich gewählt werden. Während der Durchbruch im ungetriggerten Fall nur durch einen einzigen Punkt auf der Paschenkurve festgelegt ist, lassen sich im getriggerten Fall große Spannungsbereiche ΔU oder Druckbereiche ΔP festlegen, in denen es nach dem Triggerpuls einen Durchbruch gibt.

Es ist möglich die Parameter so einzustellen, daß das Verfahren mit Wiederholfrequenzen zwischen > 0 Hz und 100 kHz betrieben wird. Gute Ergebnisse haben sich bei Wiederholfrequenzen von 10 kHz gezeigt.

Außerdem ist es möglich, das Verfahren so durchzuführen, daß es mit durch An- und Abschalten einstellbar langen Betriebsintervallen betrieben wird, während derer jeweils eine feste Wiederholfrequenz verwendet wird. Ein Betriebsintervall beginnt mit dem Anschalten und endet mit dem Abschalten. Während eines Betriebsintervalls wird beispielsweise ein Wafer in einem Teilbereich belichtet. Die für die Belichtung erforderliche Strahlung wird nach einem der vorbeschriebenen Verfahren durchgeführt, und zwar mit einer festen Wiederholfrequenz. Nach einem Betriebsintervall kann eine Verstellung der Belichtungseinrichtung und/oder des Wavers erfolgen, um dann nach erneuter Belichtung desselben Wavers oder eines anderen Wavers mit einer vorbestimmten Wiederholfrequenz das Verfahren erneut durchzuführen.

Die Erfindung bezieht sich auch auf eine Vorrichtung mit den Merkmalen des Oberbegriffs des Anspruchs 5. Bei einer solchen Vorrichtung kann es im Entladungsraum zu einer Ionisierung kommen. Die im elektrischen Feld befindlichen beweglichen Ionen treffen auf die Triggerelektrode und haben in der Regel eine hinreichend große Energie, um Sekundärelektronen aus der metallischen Oberfläche der Elektrode zu schlagen. Diese Elektronen gelangen wegen des Potentialunterschieds auf die Anode. Infolgedessen kann zwischen der Anode und der Triggerelektrode ein leitender Kanal entstehen, ohne daß es bereits zu dem gewünschten Durchbruch im Bereich der Öffnungen der Elektroden gekommen ist. Dabei kann ein merklicher Teil des Energiespeichers über den Triggerschaltkreis entladen werden, was die Gefahr einer Zerstörung dieses Kreises mit sich bringt.

Des weiteren kann ein Problem dadurch entstehen, daß das Potential der Triggerelektrode infolge der Ausbildung eines leitenden Kanals auf das Niveau der Anode abfällt, wodurch gegenüber der Kathode eine hohe Spannung ausgebildet wird. Infolge dessen können unerwünschte Entladungen zwischen der Kathode und der Triggerelektrode auftreten, die sich ebenfalls störend auf ein einwandfreier Funktionieren der Vorrichtung auswirken.

Letztlich kann ein Ionen- bzw. Teilchenstrahl dazu führen, daß er aufgrund seiner hohen Energie zumindest Teile der Kathode zerstäubt. Das führt zu unerwünschtem Verschleiß und zu Ablagerungen von Zerstäubungspartikeln auf den umliegenden Oberflächen.

Demgegenüber liegt der Erfindung die Aufgabe zugrunde, eine Vorrichtung mit den vorgenannten Merkmalen so auszubilden, daß eine hohe Lebensdauer ohne Störungen der Funktion erreicht wird.

Die vorgenannte Aufgabe wird durch die Merkmale des Kennzeichens des Anspruchs 5 gelöst. Wenn die Trägerelektrode außerhalb eines sich in der Symmetrieachse ausbildenden Teilchenstrahls angeordnet ist, treffen die in dieser Achse beschleunigten Teilchen bzw. Ionen nicht mehr auf die Trägerelektrode. Die vorbeschriebenen Fehlfunktionen werden daher zumindest erheblich gemindert. Entsprechendes gilt, wenn die Triggerelektrode eine Abschirmung aufweist, die einen Aufbau eines leitenden Kanals zwischen der Triggerelektrode und der Anode verhindert.

Eine vorteilhafte Ausbildung der Vorrichtung zeichnet sich dadurch aus, daß die Triggerelektrode in der Symmetrieachse der Öffnungen der Elektroden angeordnet ist und eine den Öffnungen zugewendete Stirnfläche zumindest im Ausbildungsbereich des Teilchenstrahls einen Isolator als Abschirmung aufweist. Die Anordnung der Triggerelektrode in der Symmetrieachse kann so getroffen werden, daß eine gleichmäßige Beeinflussung der Feldlinien im Entladungsraum sicher erreicht werden kann. Der Isolator bietet den gewünschten Schutz der Triggerelektrode, ohne dabei die Feldlinien im Entladungsraum maßgeblich zu verzerren.

Es ist vorteilhaft, wenn der Isolator als auf die Stirnfläche der Triggerelektrode aufgebrachte Schicht ausgebildet ist. Die Triggerelektrode ist in diesem Fall mit minimalem Werkstoffaufwand ausreichend geschützt.

Die Vorrichtung kann aber auch so ausgebildet sein, daß der Isolator als in die Stirnfläche der Triggerelektrode eingelassener Körper ausgebildet ist. In diesem Fall ist die Triggerelektrode mit den üblichen mechanischen Fertigungsmitteln mit dem Isolator zusammenzubauen.

Eine vorteilhafte Ausbildung der Vorrichtung kann sich dadurch auszeichnen, daß der Isolator eine Vertiefung mit einem auf den Teilchenstrahl abgestimmten Querschnitt hat. Ein Teilchenstrahl kann in diesem Fall auf einen Boden der Vertiefung treffen. Entstehende Zerstäubungsprodukte lagern sich infolgedessen hauptsächlich an den Innenwänden der Vertiefung ab und stören daher kaum die übrigen Flächen der Anordnung.

Wenn die Vertiefung des Isolators konisch verjüngt ausgebildet ist, wird die Energie eines Ionenstrahls auf eine größere Oberfläche verteilt und damit das örtliche thermische Aufheizen vermindert. Entsprechend weniger Zerstäubungsprodukte bilden sich aus.

Eine weitere Möglichkeit ist es, die Vorrichtung so auszubilden, daß die Triggerelektrode zumindest gegen den an die erste Elektrode angrenzenden Raum vollständig isoliert ist. Die Herstellung der Triggerelektrode für eine solche Vorrichtung kann durch eine vollständige Isolierung bzw. Beschichtung vorteilhaft beeinflußt werden. Auch entfallen Inhomogenitäten bei Feld- oder Entladungsausbildung an den Metalloberflächen der Triggerelektrode im Übergangsbereich zwischen isolierten und nicht isolierten Metallflächen.

Nachteilig kann bei einer vollständigen Isolierung der Triggerelektrode sein, daß sich unter bestimmten Entladungsbedingungen elektrische Ladungen auf der isolierten Oberfläche ansammeln, die eine Abschirmung des Triggerpotential bewirken könnten. Um das zu verhindern, kann die Vorrichtung so ausgebildet werden, daß die Abschirmung der Triggerelektrode eine Oberflächenladungen abbauende, aber einen entladungsbeeinflussenden Stromfluß zwischen der zweiten Elektrode und der Triggerelektrode verhindernde Restleitfähigkeit hat. Auch in diesem Fall einer Oberflächenentladungen abbauenden Abschirmung ist es vorteilhaft, die Triggerelektrode vollständig zu isolieren, um zusätzliche Ableitungswege zu vermeiden.

Wenn sich die Triggerelektrode nicht in der Symmetrieachse befinden soll, ist es zu bevorzugen, die Vorrichtung so auszubilden, daß die Triggerelektrode als die Symmetrieachse umgebender Hohlzylinder ausgebildet ist.

Insbesondere kann die Vorrichtung dahingehend ausgebildet werden, daß eine hohlzylindrische Triggerelektrode einen den zwei Elektroden abgewendeten Boden aufweist, der als Isolator ausgebildet ist oder der ein Metallboden ist, welcher das Potential einer der Elektroden hat, wozu er gegen die Triggerelektrode isoliert ist. Der Isolator kann dann die Funktionen der vorbeschriebenen Isolatoren übernehmen, insbesondere bezüglich eines etwaigen Teilchenstrahls. Wenn der Boden ein Metallboden ist, kann er entweder auf das Potential der Anode gelegt werden, so daß ein leitfähiger Kanal wegen Potentialgleichheit nicht entsteht. Der Metallboden kann aber auch auf das Potential der Kathode gelegt werden, um entstehende Ladungsträger abzusaugen.

Des weiteren ist es vorteilhaft die Vorrichtung so auszubilden, daß die Triggerelektrode eine Ringscheibe oder mindestens ein Elektrodenstift ist, die/der quer zu der Symmetrieachse der Elektroden in die erste Elektrode eingebaut ist/sind. Mit der Ringscheibe oder mit einem Elektrodenstift kann das elektrische Feld im Entladungsraum bzw. in dem an die Triggerelektrode angrenzenden Raum beeinflußt werden, um das Entladungsverhalten der Vorrichtung zu beeinflussen. Um das vorbeschriebene Ziel zu erreichen, ist die Triggerelektrode isoliert in die erste Elektrode eingebaut ist.

Die Vorrichtung ist bei ihrer Funktion erheblicher Wärmeentwicklung ausgesetzt. Es ist daher zweckmäßig, sie so auszubilden, daß die Abschirmung aus temperaturbeständigem Isolationsmaterial besteht.

Wegen der vorbeschriebenen Wärmeentwicklung ist es auch sinnvoll, daß die Abschirmung mit der Triggerelektrode thermisch gut leitfähig verbunden ist, um Wärme abzuleiten.

Um den überwiegenden Teil der Ladungsträger abzufangen, die im Bereich der Symmetrieachse auf eine Abschirmung gelangen, wird die Vorrichtung zweckmäßigerweise so ausgebildet, daß die Abschirmung einen Durchmesser aufweist, der mindestens dem Durchmesser der Öffnungen entspricht.

Die Erfindung wird anhand von in der Zeichnung dargestellten Ausführungsbeispielen erläutert. Es zeigt:
- Fig.1: eine schematische Darstellung eines Elektrodensystems,
- Fig.2: eine diagrammartige Darstellung der Abhängigkeit der Zündspannung eines Elektrodensystems vom Druck in einem Entladungsraum, und
- Fig.3: bis 13 schematisierte Darstellungen von Elektrodensystemen mit unterschiedlich ausgebildeten Triggereinrichtungen.

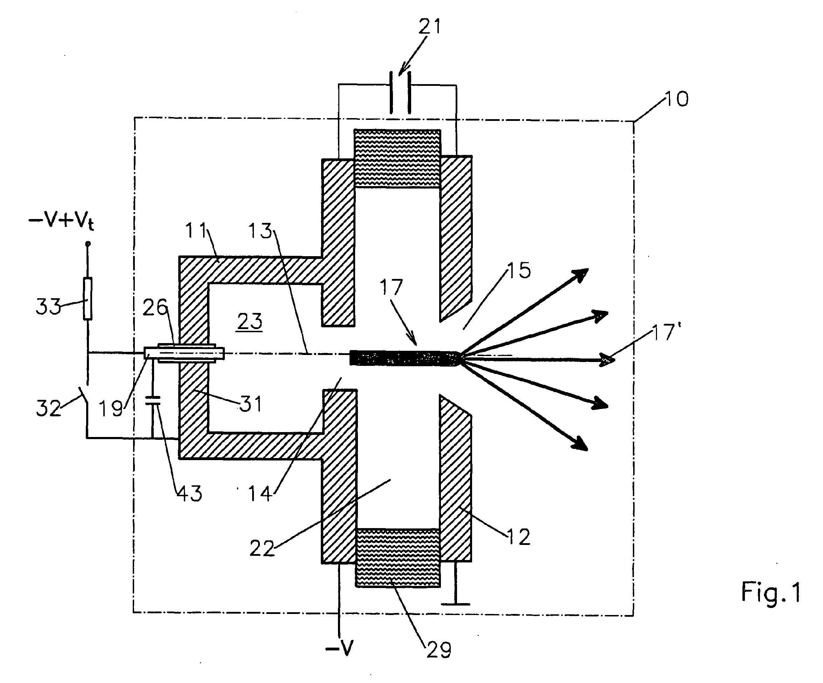

Fig.1 zeigt schematisch die Ausbildung eines in einem Entladungsraum 10 angeordneten Elektrodensystems. Der Entladungsraum 10 ist mit Gas vorbestimmten Gasdrucks gefüllt und kann von geeignet ausgebildeten Elektroden des Elektrodensystems selbst gebildet sein. Der Gasdruck ist einstellbar. Die zum Einstellen des Gasdrucks erforderliche Ausrüstung des Entladungsgefäßes 10 und eine hierauf abgestimmte Ausformung des Elektrodensystems ist vorhanden, aber nicht dargestellt.

Es sind zwei Elektroden 11,12 vorhanden. Die Elektrode 12 ist als Anode mit einer zentralen Öffnung 15 ausgebildet, die sich von einem Elektrodenzwischenraum 22 ausgehend konisch erweitert.

Die Elektrode 11 ist als Kathode ausgebildet, und zwar als Hohlkathode mit einem Hohlraum 23, der über eine Öffnung 14 der Kathode an den Elektrodenzwischenraum 22 angeschlossen ist. Die Öffnungen 14,15 fluchten und bilden eine Symmetrieachse 13 des Elektrodensystems. Die Elektroden 11,12 sind gegeneinander isoliert. Ein hierzu dienender Isolator 29 bestimmt den Elektrodenabstand.

Das Elektrodensystem ist infolge der vorbeschriebenen Ausgestaltung in der Lage, beim Anlegen einer elektrischen Hochspannung im Bereich von beispielsweise einigen 10 kV Feldlinien auszubilden, die jedenfalls im Bereich des Elektrodenzwischenraums 22 geradlinig und parallel zu der Symmetrieachse 13 verlaufen. Wird die Spannung von einem vorbestimmten tiefen Wert ausgehend impulsmäßig gesteigert, so ergibt sich eine Laderampe bzw. ein Spannungsanstieg. Es kommt zu Ionisationsvorgängen, die sich aufgrund der Feldstärkeverhältnisse im Elektrodenzwischenraum 22 konzentrieren. Hierzu sind der Spannungsanstieg und der Gasdruck so aufeinander abgestimmt, daß es infolge der Ionisierung zu einer Gasentladung auf dem linken Ast der Paschenkurve kommt, bei der ein Plasmakanal bzw. dessen Plasma nicht über eine einzige kurzzeitige Elektronenlawine aufgebaut wird, sondern mehrstufig über Sekundärionisationsprozesse. Infolgedessen ist die Plasmaverteilung bereits in der Startphase in hohem Maße zylindersymmetrisch, wie es die schematische Darstellung des Plasmas in der Fig.1 zum Ausdruck bringen soll. Das sich ausbildende Plasma 17 ist eine Quelle der zu erzeugenden Strahlung 17', einer Elektronenstrahlung.

Das ausgebildete Plasma kann als Startplasma bezeichnet werden. Es kann der Energieeinkopplung aus einem Energiespeicher im Selbstdurchbruchbetrieb dienen. Fig.1 zeigt eine Kondensatorbank 21 als Energiespeicher, der sich nach Erreichen der vorbestimmten Zündspannung entlädt und dabei ermöglicht, Strompulse im zweistelligen Kiloampere-Bereich in das Plasma einzuspeisen. Die sich infolgedessen ausbildenen Lorentz-Kräfte des Magnetfeldes schnüren das Plasma ein, so daß es zu einer hohen Leuchtdichte kommt und insbesondere zur Ausbildung extrem ultravioletter Strahlung und weicher Röntgenstrahlung, die insbesondere für die EUV-Lithographie die erforderlichen Wellenlängen aufweist.

Das in Fig. 1 dargestellte Elektrodensystem ist im Bereich der Elektrode 11 mit einer Triggereinrichtung versehen. Hierzu weist die Elektrode 11 in der Symmetrieachse 13 eine Triggerelektrode 19 auf, die von einem Isolator 26 im Boden 30 der Elektrode 11 gehalten ist. Der Isolator 26 dient dazu, daß der Triggerelektrode 19 ein Potential vermittelt werden kann, das von dem der Elektrode 11 unterschiedlich ist. Dabei hat die Triggerelektrode 19 eine parasitäre Kapazität 31 im Bezug auf die Elektrode 11, gemessen parallel zu einem Schalter 32, mit dem beide Elektroden 19,11 auf gleiches Potential gebracht werden können.

Üblicherweise ist die Elektrode 12 als Anode ausgebildet und darstellungsgemäß geerdet. Demgegenüber liegt die Kathode auf einem negativen Potential -V während die Triggerelektrode 19 auf einem Potential -V+Vₜ liegt. Das Potential der Triggerelektrode vor Beginn des Triggervorgangs ist also etwas höher, als das der Elektrode 11. Zum Zwecke der Triggerung wird ein Triggerpuls durch Schließen des Schalters 32 ausgelöst, wobei das Potential der Triggerelektrode 19 auf das der Elektrode 11 heruntergezogen wird. Typische Zeitkonstanten für eine Veränderung des Potentials der Triggerelektrode 19 liegen dabei vorteilhaft im Bereich einiger Nanosekunden bis zu einigen hundert Nanosekunden.

Die in Fig.1 schematisch dargestellte Elektrodenanordnung wird typischerweise so ausgebildet, daß zwischen den Elektroden 11,12 ein Abstand von 1 bis 10 mm vorhanden ist. Der kleinste Durchgang der Öffnungen 14,15 beträgt typischerweise 1 bis 10 mm. Das Volumen des Raums 23 in der als Hohlkathode ausgebildeten Elektrode 11 beträgt typischerweise 1 bis 10 ccm. Der Gasdruck liegt zwischen 0,01 und 1 mbar. Die Elektrodenspannung beträgt typischerweise 3 bis 30 kV und der Potentialunterschied zwischen der Triggerelektrode 19 und der Elektrode 11 beträgt zwischen 50 Volt und 1000 Volt.

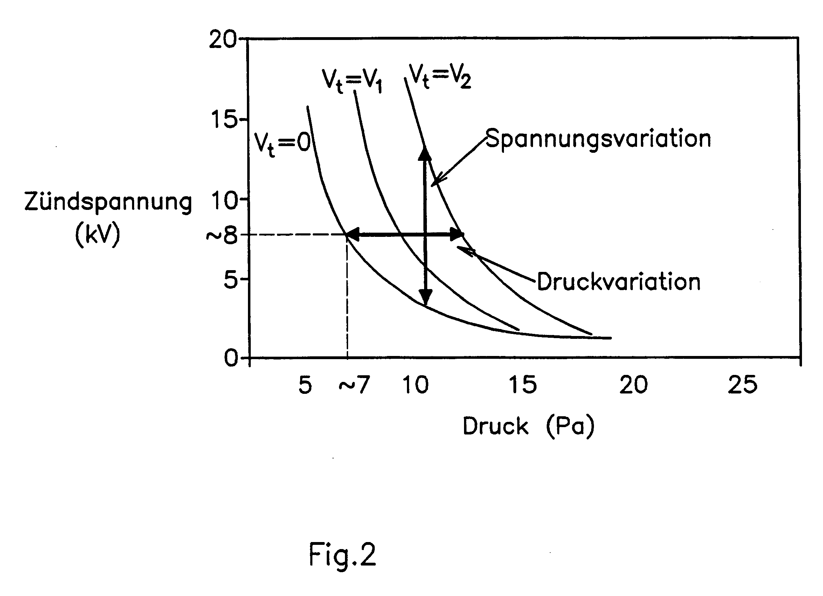

Grundsätzlich sind die Zündspannung, bei der also ein Durchbruch zwischen den Elektroden 11,12 erfolgt, und der Druck entsprechend der in Fig.2 dargestellten Kurve voneinander abhängig. Die Fig.2 bezieht sich dabei auf den linken Ast der Paschenkurve.

Die linke Kurve der Fig.2 gilt für den Betrieb der ungetriggerten Vorrichtung. Auf dieser Kurve für V=0 existiert lediglich ein einziger Durchbruchspunkt, der zum Beispiel bei einem Gasdruck von 7 Pa bei etwa 8 kV liegt. Andere Drücke im Raum 23 haben entsprechend andere Zündspannungen zur Folge. Die Triggerspannung, also der Potentialunterschied zwischen der Triggerelektrode 19 und der Elektrode 1, kann aber auch von 0 abweichen. In diesem Fall ist Vₜ nicht gleich 0 sondern zum Beispiel gleich V₁ oder V₂. Infolgedessen kann durch geeignete Bemessungen der Triggerspannung Vₜ erreicht werden, daß die Vorrichtung mit unterschiedlichen Parametern betrieben werden kann. Für eine vorbestimmte Spannung an den Elektroden 11,12 ergibt sich die Möglichkeit zur aus Fig.2 ersichtlichen Druckvariation. In ähnlicher Weise ist für einen vorbestimmten Druck die aus Fig.2 ersichtliche Spannungsvariation möglich. Entsprechend kann aber auch der Zeitpunkt des Durchbruchs mit dem Triggersignal genau festgelegt werden, ohne dadurch in einen Arbeitsbereich zu kommen, bei dem die oben beschriebenen Schwierigkeiten auftreten. Insbesondere können Wiederholfrequenzen gewährleistet werden, wie sie für den erforderlichen Einsatz notwendig sind, beispielsweise im Bereich von 10 bis 20 kHz. Auch Betriebsintervalle für vorbestimmte feste Wiederholfrequenzen sind möglich, wodurch zwischen den Betriebsintervallen die an sich für das Erzeugen der gewünschten Strahlung erforderliche Energie gespart werden kann. Die Stabilität des Arbeitspunktes wird wesentlich verbessert.

Das Triggern wird durch die in Fig.1 dargestellte Schaltung erreicht. Die Kondensatorbank 21 wird aufgeladen, indem die Elektrode 11 an negative Spannung gelegt wird, während die Elektrode 12 geerdet ist. Die Verbindung der beiden Elektroden 11,12 erfolgt über einen niederinduktiven Stromkreis mit der Kondensatorbank 21. Ein hochohmiger Stromkreis verbindet die Triggerelektrode 19 mit der Elektrode 11, wobei die Verbindung durch den Schalter 32 geöffnet werden kann. Im Öffnungsfall liegt an der Triggerelektrode 19 gegenüber der Elektrode 11 eine Potentialdifferenz Vₜ. Für diesen Fall sind die Spannungen an den Elektroden 11,12 sowie der Gasdruck des Elektrodenzwischenraums bzw. des Raums 23 der Elektrode 11 so eingestellt, daß bei Anliegen einer Triggerspannung Vₜ eine Zündung des Plasmas 17 nicht erfolgen kann. Wird der Schalter 32 hingegen geschlossen, so wird die Potentialdifferenz Vₜ beseitigt und die Triggerelektrode 19 erhält das Potential der Elektrode 11, wobei ein Schutzwiderstand 33 die Spannungsquelle der Triggerspannung schützt.

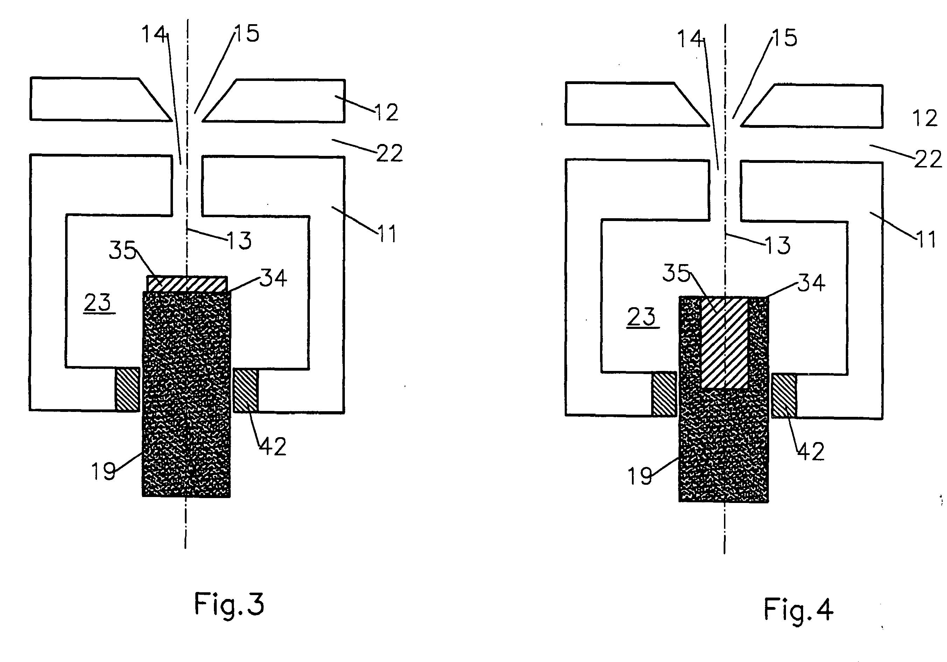

Bei offenem Schalter 32 kann es jedoch möglich sein, daß sich zwischen der Triggerelektrode 19 der Fig.1 und der als Anode dienenden Elektrode 12 ein leitender Kanal mit entsprechendem Teilchenstrahl ausbildet, der die Energie der Kondensatorbank 21 entlädt und auch zu Beschädigungen des Triggerkreises führen kann. In den Fig.3 bis 13 sind daher unterschiedlich ausgebildete Triggerelektroden in einem schematisch dargestellten System von Hauptelektroden 11,12 dargestellt, welche zu einem einwandfreien Funktionieren der Vorrichtung beitragen können.

Fig.3 bis 11 zeigen Triggerelektroden 19, die gleichachsig mit der Symmetrieachse 13 angeordnet sind, die von den Elektroden 11,12 bzw. deren Öffnungen 14,15 gebildet ist. Dabei sind die Triggerelektroden 19 der Fig.3 bis 8 so ausgebildet, daß sie der Öffnung 14 eine Stirnfläche 34 zuwenden. Zumindest diese Stirnfläche 34 ist jedoch jeweils mit einer jeweils unterschiedlich ausgebildeten Abschirmung 35 versehen. Jede Abschirmung 35 ist mindestens so groß, wie es dem Durchmesser der Öffnungen 14,15 entspricht. Die Abschirmung 35 ist also in der Nähe der Triggerelektrode 19 im Ausbildungsbereich des Teilchenstrahls vorhanden.

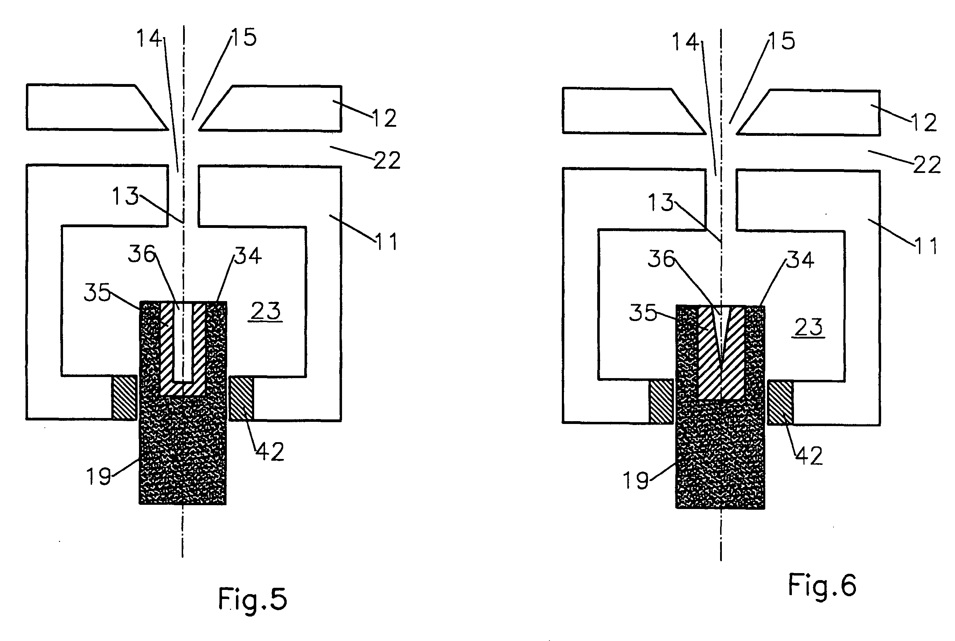

Im Falle der Fig.3 ist die Abschirmung 35 als Isolator in Form einer auf die Stirnfläche 34 der Triggerelektrode 19 aufgebrachten Schicht ausgebildet. Im Fall der Fig.4 ist ebenfalls eine Abschirmung 35 als Isolator ausgebildet, jedoch als in die Stirnfläche 34 der Triggerelektrode 39 eingelassener Körper. Der Querschnitt dieses Körpers ist beispielsweise kreiszylindrisch, um in herkömmlicher Weise in eine Bohrung der Triggerelektrode 19 eingesetzt zu werden, die von deren Stirnseite 34 her eingebracht ist. In Fig.5 und in Fig.6 ist die Triggerelektrode 19 gleich der in Fig.4 ausgebildeten. In ihre Bohrung sind jedoch unterschiedliche Abschirmungen 35 eingesetzt. Die Abschirmung 35 der Fig.5 ist wiederum ein zylindrischer Körper, der jedoch eine gleichachsige Vertiefung 36 aufweist, die als Sackloch ausgebildet ist. Der Durchmesser der Sackbohrung ist auf den Durchmesser des potentiellen Teilchenstrahls abgestimmt. Die Abschirmung 35 der Fig.6 ist mit einer Vertiefung 36 ausgebildet, die sich von den Öffnungen 14,15 weg konisch verjüngt. Ein sich etwa ausbildender Teilchenstrahl trifft auf vergleichsweise große Flächen der Abschirmung 35, so daß die Strahlenergie auf eine größere Oberfläche verteilt wird, was lokale thermische Aufheizungen verhindert. In beiden Fällen der Fig.5,6 sind die Vertiefungen dazu geeignet, infolge eines Teilchenstrahls entstehende Zerstäubungsprodukte aufzunehmen, die sich an den Innenwänden der Vertiefungen 36 ablagern können und daher kaum die übrigen Flächen der Anordnung stören.

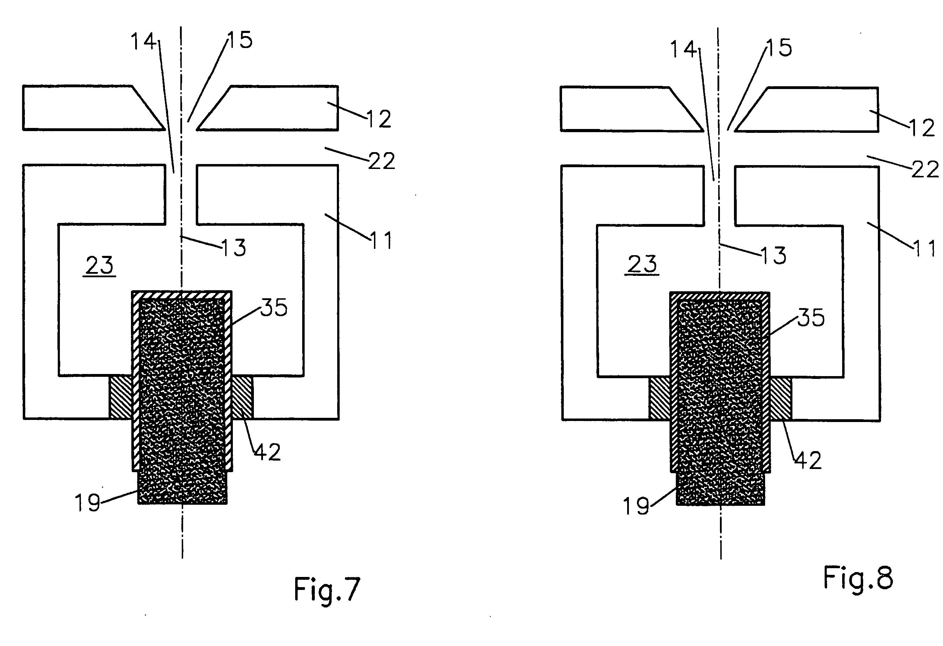

Die Triggerelektroden der Fig.7,8 zeichnen sich dadurch aus, daß sie von ihrer Abschirmung zumindest gegen den an die erste Elektrode 11 angrenzenden Raum 23 vollständig isoliert sind. Die Abschirmung 35 ist ein Überzug, der an keiner Stelle der Triggerelektrode 19 deren Oberfläche freiläßt. Infolgedessen können keine irgendwie gearteten Inhomogenitäten des elektrischen Feldes auftreten, die durch ein solches Freilassen bedingt wären. Unter bestimmten Entladungsbedingungen kann es jedoch vorkommen, daß sich auf der Oberfläche dieser Abschirmung 35 elektrische Ladungen sammeln, die eine Abschirmung der Triggerspannung bewirken können. Eine Abschirmung der Triggerspannung hätte eine Fehlfunktion der Vorrichtung zur Folge. Derartige Abschirmungen können verhindert werden, wenn die Abschirmung 35 mit einer Restleitfähigkeit versehen ist, die groß genug ist, die aufgebauten Oberflächenentladungen zu neutralisieren bzw. abzubauen. Diese Restleitfähigkeit ist jedoch nicht groß genug, einen Stromfluß zwischen der Elektrode 12 und der Triggerelektrode 19 zuzulassen, der die Kondensatorbank 21 maßgeblich entlädt. Fig.8 zeigt eine solche Abschirmung 35 mit einer geeigneten Restleitfähigkeit.

Bei allen vorbeschriebenen Ausführungsformen können die Abmessungen in weiten Grenzen variieren. So kann die Triggerelektrode 19 beispielsweise auch als dünner Draht ausgeführt sein, der dann zweckmäßigerweise gemäß Fig.7,8 beschichtet ist.

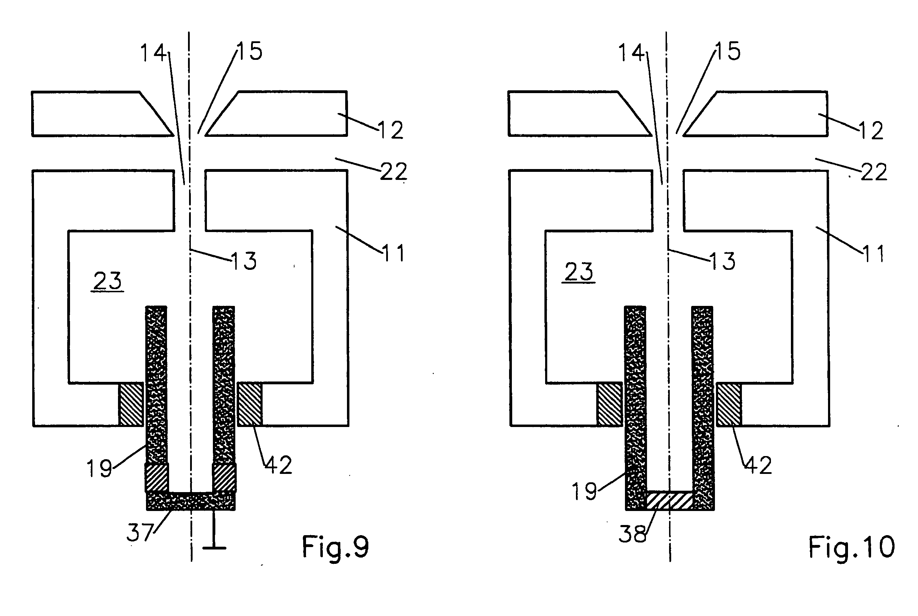

Die Triggerelektroden 19 der Fig.9 bis 11 sind hohlzylindrisch. Auch diese Triggerelektroden sind gleichachsig mit der Symmetrieachse 13 angeordnet. Infolge ihrer hohlzylindrischen Ausführung und der Feldausbildung im übrigen kann ein sich im Bereich der Symmetrieachse 13 ausbildender Teilchenstrahl nicht auf die Triggerelektrode 19 gelangen und dort störend bzw. zerstörend wirken. In Fig.9 ist die Triggerelektrode 19 von einem metallischen Boden 37 verschlossen, der auf Erdpotential liegt und gegenüber der hohlzylindrischen Triggerelektrode 19 isoliert ist. Zwischen dem Boden 37 und der Elektrode 12 kann sich kein Teilchenstrahl ausbilden, weil diese Elektrode als Anode ebenfalls auf Erdpotential liegt.

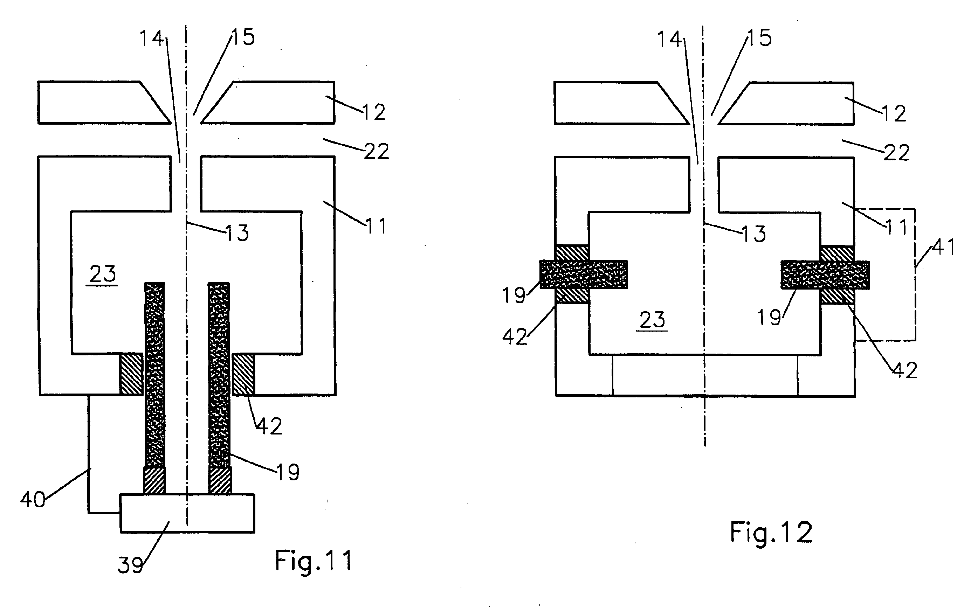

In Fig.11 ist ein Boden 38 als Isolator ausgebildet und hat damit bezüglich des Teilchenstrahls eine ähnliche Wirkung, wie die zu den Fig.3 bis 6 beschriebenen Abschirmungen. Bei Fig.11 ist der Boden 39 der hohlzylindrischen Triggerelektrode 19 als Metallelektrode ausgeführt, die mit der Elektrode 11, der Kathode, leitend verbunden ist. In der Symmetrieachse vorhandene Ladungsträger von Teilchenstrahlen werden mittels des metallischen Bodens 39 über eine Verbindungsleitung 40 der Elektrode 12 zugeführt.

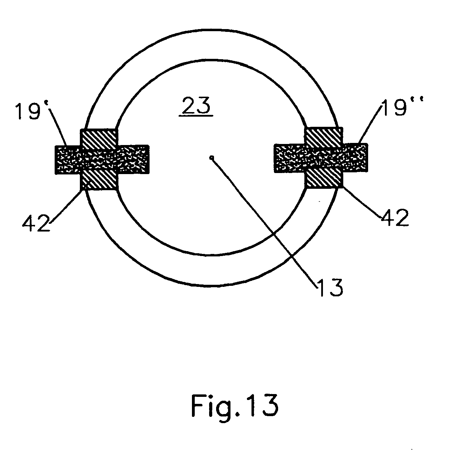

Die Ausgestaltungen der Fig.12 und 13 sind alternative Anordnungen zu Fig.11. In allen Fällen werden sich in der Symmetrieachse 13 bzw. im Raum 23 befindende Ladungsteilchen der Elektrode 11 zugeführt. In Fig.12 ist die Triggerelektrode 19 als Ringscheibe ausgebildet. Diese Ringscheibe ist quer zur Symmetrieachse 13 der Elektroden 11,12 in die erste Elektrode 11 eingebaut. Deren in Fig.12 obere und untere Hälfte sind durch eine gestrichelt dargestellte Leitung 41 leitend verbunden, haben also dasselbe Potential. Die Anordnung der Triggerelektrode 19 ist in Bezug auf die Symmetrieachse 13 zylindersymmetrisch. Das ist im Fall der Fig.13 nicht mehr der Fall. Bei dieser Ausgestaltung kann - bis auf die Leitung 41 - die von der Seite gesehene Ausgestaltung sein, wie es in Fig.12 dargestellt wurde. Die Symmetrieachse 13 steht in Fig.13 jedoch senkrecht zur Darstellungsebene und Fig.13 zeigt zwei gleich ausgebildete Teile 19' und 19'' einer Triggerelektrode, die gleichachsig und quer zur Symmetrieachse 13 angeordnet sind. Die Teile 19',19'' stellen Elektrodenstifte dar. Statt der zwei Teile 19,19' kann die Triggerelektrode jedoch auch mehrere Teile haben.

Die bei den Triggerelektroden 19 eingesetzten Abschirmungen 35 bestehen aus temperaturbeständigen Isolationsmaterialien, wie zum Beispiel Al₂O₃, Quarz oder Siliziumkarbit. Alle für Abschirmungen 35 verwendeten Materialien sind thermisch gut leitend mit der Triggerelektrode 19 verbunden.

Darüber hinaus versteht es sich, daß die Triggerelektrode 19 bzw. ihre Teile 19',19'' isoliert in die erste Elektrode 11 eingebaut ist/sind. Die in den Figuren 3 bis 13 dargestellten Isolierungen 42 erfüllen dieselben Funktionen, wie der Isolator 26 der Fig.1. Die betreffende Isolierung 42 ist jeweils temperaturbeständig.

## Patentansprüche

1. Verfahren zum Erzeugen von extrem ultravioletter Strahlung und weicher Röntgenstrahlung mit einer auf dem linken Ast der Paschenkurve betriebenen Gasentladung, insbesondere für die EUV-Lithographie,
bei dem ein Entladungsraum (10) vorbestimmten Gasdrucks und zwei Elektroden (11,12) verwendet werden, die jeweils eine auf derselben Symmetrieachse (13) gelegene Öffnung (14,15) haben, und die im Verlauf eines Spannungsanstiegs (16) beim Erreichen einer vorbestimmten Zündspannung (U_{z}) ein im Bereich ihrer Öffnungen (14, 15) gelegenes Plasma (17) ausbilden, das eine Quelle der zu erzeugenden Strahlung (17') ist,
bei dem eine Zündung des Plasmas (17) durch eine Triggerung erfolgt,
und bei dem mit der Zündung des Plasmas (17) ein Energiespeicher mittels der Elektroden (11,12) Speicherenergie in das Plasma (17) einspeist, **dadurch gekennzeichnet, daß** die Zündung des Plasmas (17) mit einer Triggerelektrode (19) erfolgt, deren Potential vor Beginn des Triggervorgangs höher als das einer (11) der als Kathode verwendeten Elektroden (11,12) ist.

2. Verfahren nach Anspruch 1, **dadurch gekennzeichnet, daß** eine Spannung der Triggerelektrode (19) gegenüber der als Kathode verwendeten Elektrode (11), die Spannung an den beiden Elektroden (11,12) und der Gasdruck des Entladungsraums (10) so eingestellt werden, daß bei Anliegen der Triggerspannung eine Zündung des Plasmas (17) nicht erfolgt, die erst mittels Abschaltens der Triggerspannung eingeleitet wird.

3. Verfahren nach Anspruch 1 oder 2, **dadurch gekennzeichnet, daß** es mit Wiederholfrequenzen zwischen > 0 Hz und 100 kHz betrieben wird.

4. Verfahren nach einem der Ansprüche 1 bis 3, **dadurch gekennzeichnet, daß** es mit durch An- und Abschalten einstellbar langen Betriebsintervallen betrieben wird, während derer jeweils eine feste Wiederholfrequenz verwendet wird.

5. Vorrichtung zum Erzeugen von extrem ultravioletter Strahlung und weicher Röntgenstrahlung mit einer auf dem linken Ast der Paschenkurve betriebenen Gasentladung, bei der eine erste und eine zweite Elektrode (11, 12) vorhanden sind, die jeweils eine auf derselben Symmetrieachse (13) gelegene und voneinander entlang dieser Symmetrieachse (13) beabstandete Öffnung (14, 15) haben, und im Bereich deren Öffnungen (14, 15) sich im Verlauf eines Spannungsanstiegs (16) beim Erreichen einer vorbestimmten Zündspannung (U_{z}) ein Plasma (17) ausbildet, das eine Quelle der zu erzeugenden Strahlung (17') ist, bei der in einem an die erste Elektrode (11) angrenzenden Raum (23), der auf einer von der zweiten Elektrode (12) abgewandten Seite an die erste Elektrode (11) angrenzt, eine Triggerelektrode (19) für eine durch Triggerung erfolgende zündung des Plasmas (17) vorhanden ist, und bei der ein mittels der Elektroden (11, 12) Speicherenergie in das Plasma (17) einspeisender Energiespeicher vorhanden ist,
**dadurch gekennzeichnet, dass** die Triggerelektrode (19) außerhalb eines sich in der Symmetrieachse (13) ausbildenden Teilchenstrahls angeordnet ist, oder eine Abschirmung (35) gegen den Teilchenstrahl aufweist.

6. Vorrichtung nach Anspruch 5, **dadurch gekennzeichnet, daß** die Triggerelektrode (19) in der Symmetrieachse der Öffnungen (14,15) der Elektroden (11,12) angeordnet ist und eine den Öffnungen (14,15) zugewendete Stirnfläche (34) zumindest im Ausbildungsbereich des Teilchenstrahls einen Isolator als Abschirmung (35) aufweist.

7. Vorrichtung nach Anspruch 6, **dadurch gekennzeichnet, daß** der Isolator als auf die Stirnfläche (34) der Triggerelektrode (19) aufgebrachte Schicht ausgebildet ist.

8. Vorrichtung nach Anspruch 6, **dadurch gekennzeichnet, daß** der Isolator als in die Stirnfläche (34) der Triggerelektrode (19) eingelassener Körper ausgebildet ist.

9. Vorrichtung nach Anspruch 8, **dadurch gekennzeichnet, daß** der Isolator eine Vertiefung (36) mit einem auf den Teilchenstrahl abgestimmten Querschnitt hat.

10. Vorrichtung nach Anspruch 9, **dadurch gekennzeichnet, daß** die Vertiefung (36) des Isolators konisch verjüngt ausgebildet ist.

11. Vorrichtung nach einem der Ansprüche 5 bis 10, **dadurch gekennzeichnet, daß** die Triggerelektrode (19) zumindest gegen den an die erste Elektrode (11) angrenzenden Raum (23) vollständig isoliert ist.

12. Vorrichtung nach einem der Ansprüche 5 bis 11, **dadurch gekennzeichnet, daß** die Abschirmung (35) der Triggerelektrode (19) eine Oberflächenladungen abbauende, aber einen entladungsbeeinflussenden Stromfluß zwischen der zweiten Elektrode (12) und der Triggerelektrode (19) verhindernde Restleitfähigkeit hat.

13. Vorrichtung nach Anspruch 5, **dadurch gekennzeichnet, daß** die Triggerelektrode (19) als die Symmetrieachse umgebender Hohlzylinder ausgebildet ist.

14. Vorrichtung nach Anspruch 13, **dadurch gekennzeichnet, daß** eine hohlzylindrische Triggerelektrode (19) einen den zwei Elektroden (11,12) abgewendeten Boden aufweist, der als Isolator ausgebildet ist oder der ein Metallboden ist, welcher das Potential einer der Elektroden (11,12) hat, wozu er gegen die Triggerelektrode (19) isoliert ist.

15. Vorrichtung nach Anspruch 5, **dadurch gekennzeichnet, daß** die Triggerelektrode (19) eine Ringscheibe oder mindestens ein Elektrodenstift ist, die/der quer zu der Symmetrieachse (13) der Elektroden (11,12) in die erste Elektrode (11) eingebaut ist/sind.

16. Vorrichtung nach einem der Ansprüche 5 bis 15, **dadurch gekennzeichnet, daß** die Triggerelektrode (19) isoliert in die erste Elektrode (11) eingebaut ist.

17. Vorrichtung nach einem der Ansprüche 5 bis 16, **dadurch gekennzeichnet, daß** die Abschirmung (35) aus temperaturbeständigem Isolationsmaterial besteht.

18. Vorrichtung nach einem der Ansprüche 5 bis 17, **dadurch gekennzeichnet, daß** die Abschirmung (35) mit der Triggerelektrode (19) thermisch gut leitfähig verbunden ist.

19. Vorrichtung nach einem der Ansprüche 5 bis 18, **dadurch gekennzeichnet, daß** die Abschirmung (35) einen Durchmesser aufweist, der mindestens dem Durchmesser der Öffnungen (14,15) entspricht.

## Claims

1. A method for generating extreme ultraviolet radiation and soft x-ray radiation using a gas discharge operated on the left branch of the Paschen curve, in particular for EUV lithography,
in which a discharge chamber (10) of predetermined gas pressure and two electrodes (11, 12) are used, which each have one opening (14, 15) placed on the same axis of symmetry (13), and which implement a plasma (17), which is a source of the radiation (17') to be generated, located in the area of their openings (14, 15) in the course of a voltage rise (16) upon reaching a predetermined ignition voltage (U_{z}),
in which an ignition of the plasma (17) is performed by triggering,
and in which an energy accumulator feeds stored energy into the plasma (17) using the electrodes (11, 12) with the ignition of the plasma (17), **characterized in that** the ignition of the plasma (17) is performed using a trigger electrode (19), whose potential before the beginning of the trigger action is higher than that of one (11) of the electrodes (11, 12) used as a cathode.

2. The method according to Claim 1, **characterized in that** a voltage of the trigger electrode (19) in relation to the electrode (11) used as a cathode, the voltage at the two electrodes (11, 12), and the gas pressure of the discharge chamber (10) are set so that upon application of the trigger voltage, an ignition of the plasma (17) does not occur, which is only initiated via a shutdown of the trigger voltage.

3. The method according to Claim 1 or 2, **characterized in that** it is operated using repetition frequencies between > 0 Hz and 100 kHz.

4. The method according to one of Claims 1 through 3, **characterized in that** it is operated using operating intervals, which are settable in length by startup and shutdown, during each of which a fixed repetition frequency is used.

5. A device for generating extreme ultraviolet radiation and soft x-ray radiation using a gas discharge operated on the left branch of the Paschen curve, in which a first and a second electrode (11, 12) are provided, which each have an opening placed on the same axis of symmetry (13) and spaced apart from one another along this axis of symmetry (13), and implement a plasma (17), which is a source of the radiation (17') to be generated, in the area of their openings (14, 15) in the course of a voltage rise (16) upon reaching a predetermined trigger voltage (U_{z}), in which a trigger electrode (19) for an ignition of the plasma (17) performed by triggering is provided in a chamber (23) adjoining the first electrode (11), which adjoins the first electrode (11) on the side facing away from the second electrode (12), and in which an energy accumulator which feeds stored energy into the plasma (17) using the electrodes (11, 12) is provided,
**characterized in that** the trigger electrode (19) is situated outside a particle beam which is implemented in the axis of symmetry (13), or has a shielding (35) in relation to the particle beam.

6. The device according to Claim 5, **characterized in that** the trigger electrode (19) is situated in the axis of symmetry of the openings (14, 15) of the electrodes (11, 12) and a front face (34) facing toward the openings (14, 15) has an insulator as the shielding (13) at least in the implementation area of the particle beam.

7. The device according to Claim 6, **characterized in that** the insulator is implemented as a layer applied to the front face (34) of the trigger electrode (19).

8. The device according to Claim 6, **characterized in that** the isolator is implemented as a body inlaid in the front face (34) of the trigger electrode (19).

9. The device according to Claim 8, **characterized in that** the insulator has a depression (36) having a cross-section adapted to the particle beam.

10. The device according to Claim 9, **characterized in that** the depression (36) of the insulator is implemented as conically tapered.

11. The device according to one of Claims 5 through 10, **characterized in that** the trigger electrode (19) is completely insulated at least in relation to the chamber (23) adjoining the first electrode (11).

12. The device according to one of Claims 5 through 11, **characterized in that** the shielding (35) of the trigger electrode (19) has a residual conductivity which dissipates surface charges, but prevents a discharge-influencing current flow between the second electrode (12) and the trigger electrode (19).

13. The device according to Claim 5, **characterized in that** the trigger electrode (19) is implemented as a hollow cylinder which encloses the axis of symmetry.

14. The device according to Claim 13, **characterized in that** a hollow-cylindrical trigger electrode (19) has a floor facing away from the two electrodes (11, 12), which is implemented as an insulator or is a metal floor, which has the potential of one of the electrodes (11, 12), for which purpose it is insulated in relation to the trigger electrode (19).

15. The device according to Claim 5, **characterized in that** the trigger electrode (19) is a ring disc or at least one electrode pin, which is/are installed in the first electrode (11) transversely to the axis of symmetry (13) of the electrodes (11, 12).

16. The device according to one of Claims 5 through 15, **characterized in that** the trigger electrode (19) is installed in an insulated manner in the first electrode (11).

17. The device according to one of Claims 5 through 16, **characterized in that** the shielding (35) is made of high-temperature-resistant insulation material.

18. The device according to one of Claims 5 through 17, **characterized in that** the shielding (35) is connected to the trigger electrode (19) in a manner having good thermal conductivity.

19. The device according to one of Claims 5 through 18, **characterized in that** the shielding (35) has a diameter which at least corresponds to the diameter of the openings (14, 15).

## Revendications

1. Procédé de génération de rayonnement extrêmement ultraviolet et de rayonnement radiographique modéré par une décharge de gaz actionnée sur la branche gauche de la courbe Paschen, notamment pour la lithographie EUV,
dans lequel on emploie une chambre de décharge (10) à pression de gaz prédéfinie et deux électrodes (11, 12) qui présentent respectivement un orifice (14, 15) situé sur le même axe de symétrie (13) et qui, au cours d'une hausse de tension (16) à l'atteinte d'une tension d'allumage prédéfinie (U_{z}), forment un plasma (17) situé au niveau de leurs orifices (14, 15) et constituant une source du rayonnement (17') à générer,
dans lequel un allumage du plasma (17) est assuré par un déclenchement
et dans lequel, à l'allumage du plasma (17), un accumulateur d'énergie apporte dans le plasma (17) de l'énergie accumulée au moyen des électrodes (11, 12), **caractérisé en ce que** l'allumage du plasma (17) se fait à l'aide d'une électrode de déclenchement (19) dont le potentiel est, avant le début du processus de déclenchement, supérieur à celui d'une (11) des électrodes utilisées comme cathodes (11, 12).

2. Procédé selon la revendication 1, **caractérisé en ce qu'**une tension de l'électrode de déclenchement (19) par rapport à l'électrode utilisée comme cathode (11), la tension au niveau des deux électrodes (11, 12) et la pression gazeuse de la chambre de décharge (10) sont réglées de manière à ce que, en cas de présence de la tension de déclenchement, il n'y ait pas d'allumage du plasma (17), l'allumage n'étant initié qu'au moyen d'une coupure de la tension de déclenchement.

3. Procédé selon la revendication 1 ou 2, **caractérisé en ce qu'**il fonctionne à des fréquences de répétition comprises entre > 0 Hz et 100 kHz.

4. Procédé selon une des revendications 1 à 3, **caractérisé en ce qu'**il fonctionne avec des intervalles de fonctionnement de longueur réglable par activation et coupure pendant lesquels une fréquence de répétition fixe est respectivement utilisée.

5. Dispositif de génération de rayonnement extrêmement ultraviolet et de rayonnement radiographique modéré par une décharge de gaz actionnée sur la branche gauche de la courbe Paschen, dans lequel sont présentes une première et une deuxième électrodes (11, 12) qui présentent respectivement un orifice (14, 15) situé sur le même axe de symétrie (13) et espacé des autres le long de cet axe de symétrie (13) et, au niveau de leurs orifices (14, 15), se forme, au cours d'une hausse de tension (16) à l'atteinte d'une tension d'allumage prédéfinie (U_{z}), un plasma (17) qui est une source du rayonnement (17') à générer, dans lequel, dans une chambre (23) adjacente à la première électrode (11) et qui, du côté détourné de la deuxième électrode (12), est adjacente à la première électrode (2), se trouve une électrode de déclenchement (19) pour un allumage se faisant par déclenchement du plasma (17) et dans lequel se trouve un accumulateur d'énergie apportant de l'énergie accumulée au moyen des électrodes (11, 12) dans le plasma (17),
**caractérisé en ce que** l'électrode de déclenchement (19) est disposée en dehors d'un rayon de particules se formant dans l'axe de symétrie (13) ou présente un blindage (35) contre le rayon de particules.

6. Dispositif selon la revendication 5, **caractérisé en ce que** l'électrode de déclenchement (19) est disposée dans l'axe de symétrie des orifices (14, 15) des électrodes (11, 12) et une surface frontale (34) tournée vers les orifices (14, 15) présente un isolateur faisant office de blindage (35) au moins dans la zone de formation du rayon de particules.

7. Dispositif selon la revendication 6, **caractérisé en ce que** l'isolateur se présente sous la forme d'une couche appliquée sur la surface frontale (34) de l'électrode de déclenchement (19).

8. Dispositif selon la revendication 6, **caractérisé en ce que** l'isolateur se présente sous la forme d'un corps encastré dans la surface frontale (34) de l'électrode de déclenchement (19).

9. Dispositif selon la revendication 8, **caractérisé en ce que** l'isolateur comporte un renfoncement (36) dont la section transversale est adaptée au rayon de particules.

10. Dispositif selon la revendication 9, **caractérisé en ce que** le renfoncement (36) de l'isolateur a une conformation effilée en cône.

11. Dispositif selon une des revendications 5 à 10, **caractérisé en ce que** l'électrode de déclenchement (19) est totalement isolée du moins par rapport à la chambre (23) adjacente à la première électrode (11).

12. Dispositif selon une des revendications 5 à 11, **caractérisé en ce que** le blindage de l'électrode de déclenchement (19) a une conductivité résiduelle éliminant les charges surfaciques mais empêchant un flux électrique jouant sur la décharge entre la deuxième électrode (12) et l'électrode de déclenchement (19).

13. Dispositif selon la revendication 5, **caractérisé en ce que** l'électrode de déclenchement (19) se présente sous la forme d'un cylindre creux entourant l'axe de symétrie.

14. Dispositif selon la revendication 13, **caractérisé en ce qu'**une électrode de déclenchement cylindrique creuse (19) présente une base détournée des deux électrodes (11, 12) qui se présente sous forme d'un isolateur ou qui est une base métallique qui a le potentiel d'une des électrodes (11, 12), ce pour quoi elle est isolée par rapport à l'électrode de déclenchement (19).

15. Dispositif selon la revendication 5, **caractérisé en ce que** l'électrode de déclenchement (19) est une rondelle ou au moins une tige d'électrode qui est intégrée transversalement à l'axe de symétrie (13) des électrodes (11, 12) dans la première électrode (11).

16. Dispositif selon une des revendications 5 à 15, **caractérisé en ce que** l'électrode de déclenchement (19) est intégrée avec une isolation dans la première électrode (11).

17. Dispositif selon une des revendications 5 à 16, **caractérisé en ce que** le blindage (35) est composé de matériau isolant résistant à la chaleur.

18. Dispositif selon une des revendications 5 à 17, **caractérisé en ce que** le blindage (35) est relié avec une bonne conductivité thermique à l'électrode de déclenchement (19).

19. Dispositif selon une des revendications 5 à 18, **caractérisé en ce que** le blindage (35) présente un diamètre qui équivaut au moins au diamètre des orifices (14, 15).
